# EUROPEAN PATENT SPECIFICATION

(11) **EP 3 935 482 B1**
(45) Date of publication and mention of the grant of the patent: **02.12.2026**
(21) Application number: 20711289.7
(22) Date of filing: 09.03.2020
(51) Int. Cl.: G06F 3/044, G06V 40/13

(54) **HIGH RESOLUTION TOUCH SENSOR APPARATUS AND METHOD**
BERÜHRUNGSSENSORVORRICHTUNG MIT HOHER AUFLÖSUNG UND VERFAHREN
APPAREIL ET PROCÉDÉ DE CAPTEURS TACTILES À HAUTE RÉSOLUTION

(30) Priority: 07.03.2019 GB 201903093
(43) Date of publication of application: 12.01.2022
(73) Proprietor: Touch Biometrix B.V., 6005 NX Weert (NL)
(72) Inventor: DERCKX, Henricus, St Asaph LL17 0JD (GB); VAN LIER, Wilhelmus, St Asaph LL17 0JD (GB); COWIN, Michael A, St Asaph LL17 0JD (GB)
(74) Representative: Leach, Sean Adam
(86) International application number: PCT/GB2020/050560
(87) International publication number: WO 2020/178605

(56) References cited:
- US-A1- 2006 076 963
- US-A1- 2006 097 735
- US-A1- 2014 266 262
- US-A1- 2017 006 245
- US-A1- 2017 351 364

## Description

### Field of Invention

The present invention relates to apparatus and methods, and more particularly to touch sensitive surfaces, methods for control and signal acquisition from such surfaces, and methods of manufacturing such surfaces.

### Background

Secure, verifiable authentication, of user identity is an increasingly important part of all technology. To give just a few examples, it plays a part in:
- user equipment (UE) used for communication and consumer access to media content,
- computer devices and systems which store and provide access to sensitive data,
- devices and systems used for financial transactions, access control for buildings, and
- access control for vehicles.

Biometric measurement of the user is now prevalent in all of these contexts and others. Biometric measures such as iris scanning, and facial recognition are dependent on lighting and field of view of a camera. It may also be possible to circumvent such security measures by presenting a video or photo of the user to the camera.

Fingerprint sensors have been thought of as being more secure, but it is possible also to overcome the security they provide, and the manufacturing requirements of such sensors makes it difficult to integrate them into other electronic devices such as mobile telephones and other UEs. In particular, fingerprint sensing demands very high resolution - at least hundreds of pixels per inch.

One example of such a sensor is Apple Inc's Touch ID (RTM). This sensor is based on a laser-cut sapphire crystal. It uses a detection ring around the sensor to detect the presence of the user's finger. The Touch ID (RTM) sensor uses capacitive touch sensing to detect the fingerprint, and has a 500 pixel per inch (PPI) resolution.

Capacitance sensors such as these use capacitive effects associated with the surface contours of the fingerprint. The sensor array pixels each include an electrode which acts as one plate of a capacitor, the dermal layer (which is electrically conductive) acts as the other plate, and the non-conductive epidermal layer acts as a dielectric. The capacitance is greater where the dermis is closer to the pixel electrode, and so the surface contours of the skin can be sensed by measuring the capacitance of each pixel (e.g. based on the charge accumulated on the pixel electrode) and assembling an image from those pixels.

Both passive matrix and active matrix capacitive touch sensors have been proposed. Most so-called passive capacitive touch sensing systems use an external driving circuit (such as an integrated circuit, IC) to drive a matrix of passive electrodes, and a separate readout circuit (e.g. an IC) to readout charge stored on these electrodes during the drive cycle. The stored charge varies dependent on the tiny capacitance changes due to touch events. Passive electrode systems are sensitive to environmental noise and interference.

Active matrix capacitive touch sensors include a switching element in each pixel. The switching element may control a conduction path between the capacitive sensing electrode in the pixel, and an input channel to an analogue to digital converter (ADC) in a read-out circuit. Typically each column of pixels in an active array is connected to one such input channel. The charge stored in the array can thus be read from the active matrix by controlling the switching elements to connect each row of pixels, one-by-one, to the ADC.

Each pixel needs to be connected to the read-out circuit, and all of the pixels of each column are effectively connected in parallel. The parasitic capacitance associated with each pixel therefore combines additively. This places an inherent limit on the number of pixels that can be combined together in any one column. This in turn limits the size and/or resolution of a capacitive touch sensor.

There thus remains a significant unmet commercial need for large area high resolution touch sensors.

US2014266262 describes a fingerprint sensor pixel and fingerprint imaging device. The fingerprint sensor pixel includes a capacitive sensor and a readout circuit. The capacitance of the capacitive sensor changes in response to contact with a fingerprint. The readout circuit includes a first thin film transistor (TFT) used to convert the capacitance of the capacitive sensor to a representative current, a coupling capacitor used to capacitively couple a readout pulse to the gate of the said second TFT sharing the connection with the capacitive sensor pixel, and a second TFT used to reset the voltage of the capacitive sensor.

US2006097735 describes an electrostatic capacitance detection device, that includes: an electrostatic capacitance detection element arranged in a matrix form; a row line arranged in each row for selecting a relevant electrostatic capacitance detection element arranged in a relevant row; an output line arranged in each column for outputting a signal from a relevant electrostatic capacitance detection element arranged in a relevant column, wherein the each electrostatic capacitance detection element is provided with a row selection element that controls the outputting of the signal of the relevant electrostatic capacitance detection element to the relevant output line based on the signal from the relevant row, and the signal from the relevant electrostatic capacitance detection element, which is caused to be in a selection state based on the signal from the relevant row line, is outputted to the output line arranged in the relevant electrostatic capacitance detection element. US2017351364 describes a method for driving a display device capable of scanning an image.

US2017006245 describes an array of sensing pixels configured to sense an input object in a sensing region.

US2006076963 describes an electrostatic capacitance detection device.

### Summary

Aspects and examples of the invention are set out in the claims and aim to address at least a part of the above described technical problem, and other problems.

The invention is defined by the appended claims.

In an aspect there is provided a sensor array comprising a plurality of touch sensitive pixels, each pixel comprising: a capacitive sensing electrode for accumulating a charge in response to proximity of a conductive object to be sensed; a reference capacitor connected in series with the capacitive sensing electrode so that, in response to a control voltage, an indicator voltage is provided at the connection (18) between the reference capacitor and the capacitive sensing electrode to indicate the proximity of the conductive object to be sensed. This arrangement may reduce or overcome the problem associated with parasitic capacitance which may occur in prior art touch sensors. Each pixel may comprise a sense VCI (voltage controlled impedance) having a control terminal connected so that the impedance of the sense VCI is controlled by the indicator voltage. Typically the sense VCI comprises at least one TFT (thin film transistor) and the conduction path of the VCI comprises the channel of the TFT. A conduction path of the sense VCI may be connected to a first plate of the reference capacitor (16), and the control terminal of the first VCI is connected to the second plate of the reference capacitor. At least one plate of the reference capacitor may be provided by a metallisation layer of a thin film structure which provides the sense VCI.

The conduction path of the sense VCI may connect the first plate of the reference capacitor, and so also the control voltage, to an input of a readout circuit. This may enable the circuitry which provides the control voltage also to provide the basis for the output signal of the pixel. This may further address problems associated with parasitic capacitance and signal to noise ratio in prior art touch sensors. An alternative way to address this same problem is to arrange the conduction path of the sense VCI to connect a reference signal supply to an input of a readout circuit. The reference signal supply may comprise a constant voltage current source. Thus, modulating the impedance of the sense VCI of a pixel controls the current from that pixel to the input of the read-out circuit.

A select VCI may also be included in each pixel. This may be connected so that its conduction path is connected in series between the conduction path of the sense VCI and the reference signal supply. Thus, switching the select VCI into a nonconducting state can isolate the sense VCI from the reference signal input, whereas switching the select VCI into a conducting state can enable current to flow through the pixel (depending on the impedance of the sense VCI). A control terminal of the select VCI may be connected for receiving the control voltage, e.g. from a gate drive circuit.

Each pixel may comprise a reset circuit for setting the control terminal (22) of the sense VCI to a selected reset voltage. The reset circuit may comprise a reset VCI. A conduction path of the reset VCI is connected between a second plate of the reference capacitor and one of (a) a reset voltage; and (b) a first plate of the reference capacitor. A control terminal (32) of the reset VCI may be connected to another pixel of the sensor for receiving a reset signal (e.g. from a channel of a gate drive circuit which is connected to the control terminal of the select VCI of a pixel in another row of the array). The reset signal may be configured to switch the reset VCI into a conducting state, thereby to connect the second plate of the reference capacitor to the one of (a) the reset voltage and (b) the first plate of the capacitor. Connecting the second plate of the reference capacitor to the one of (a) the reset voltage.

Each pixel may comprise a gate line VCI, and a conduction path of the gate line VCI may connect the reference signal supply to the first plate of the reference capacitor for providing the control voltage.

An aspect also provides a method of operating a sensor array comprising a plurality of touch sensitive pixels, the method comprising: applying a control voltage to a reference capacitor of a pixel of the sensor to charge the reference capacitor and a capacitive sensing electrode, wherein the reference capacitor and the capacitive sensing electrode together provide, in response to the control voltage, an indicator voltage indicative of the proximity of a conductive object to be sensed by the pixel.

The indicator voltage may be used to control the impedance of a conduction path of a sense VCI connected to an input channel of a readout circuit. The control voltage may be provided by an output channel of a gate drive circuit, and the output channel of the gate drive circuit may be connected to the input channel of the readout circuit via the conduction path of the sense VCI. The method may comprise operating the sense VCI to modulate the impedance of a conduction path between the output channel of the gate drive circuit and the input channel of the readout circuit. This may help to address problems associated with parasitic capacitance from other pixels in the same column from swamping signal from the active pixel. An alternative way to address this same technical problem is provided when a reference signal supply is connected to the input channel of the readout circuit by the conduction path of the sense VCI. In these embodiments, the method may comprise operating the sense VCI to modulate the impedance of a conduction path between the reference signal supply and the input channel of the readout circuit.

The method may comprise operating a gate line VCI to provide the control voltage by connecting the reference signal supply to the reference capacitor via a conduction path of the gate line VCI.

The method may comprise resetting the reference capacitor prior to a subsequent application of the control voltage. Resetting the reference capacitor may comprise operating a reset circuit using a control voltage which is also applied to another pixel of the sensor array - for example a control voltage which is used to activate another row of pixels of the array.

Resetting the reference capacitor may comprise operating a reset VCI to connect a first plate of the reference capacitor to one of: (a) a reset voltage; and (b) a second plate of the reference capacitor. Resetting the reference capacitor may comprise connecting the first and second plates of the reference capacitor to each other.

An aspect also provides an individual pixel comprising: a capacitive sensing electrode for accumulating a charge in response to proximity of a conductive object to be sensed; a reference capacitor connected in series with the capacitive sensing electrode so that, in response to a control voltage, an indicator voltage is provided at the connection (18) between the reference capacitor and the capacitive sensing electrode to indicate the proximity of the conductive object to be sensed. Embodiments may provide a group of such pixels, such as may provide a component part of such an array.

For the avoidance of doubt, the disclosure of this application is intended to be considered as a whole. Any feature of any one of the examples disclosed herein may be combined with any selected features of any of the other examples described herein.

For example, features of methods may be implemented in suitably configured hardware, and the functionality of the specific hardware described herein may be employed in methods which may implement that same functionality using other hardware.

### Brief Description of Drawings

Some practical implementations will now be described, by way of example only, with reference to the accompanying drawings in which:
**Figure 1** comprises a plan view of a sensor apparatus comprising a sensor array, and Inset A of Figure 1 shows a circuit diagram for a pixel of the sensor array;
**Figure 2** shows a circuit diagram of a sensor array for a sensor apparatus such as that illustrated in Figure 1;
**Figure 3** shows a circuit diagram of another sensor array of the type shown in Figure 1;
**Figure 4** shows a signal timing diagram for the operation of a pixel in a sensor array of the type shown in Figure 3;
**Figure 5** shows a circuit diagram of a pixel for use in a sensor array such as that illustrated in Figure 3;
**Figure 6** shows a circuit diagram of another pixel for use in a sensor array such as that illustrated in Figure 3.

In the drawings like reference numerals are used to indicate like elements.

### Specific Description

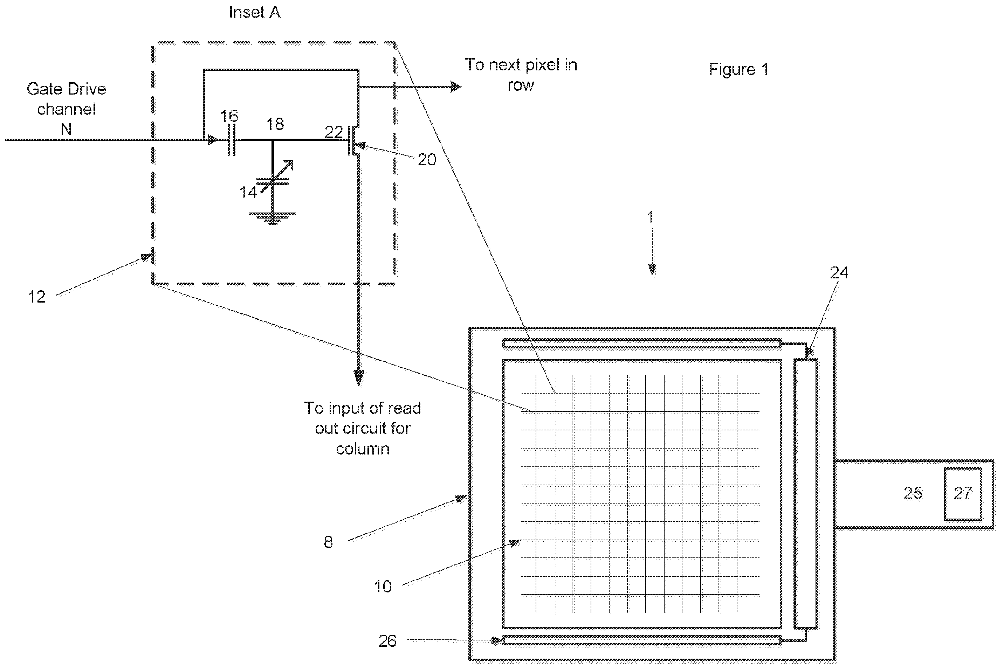

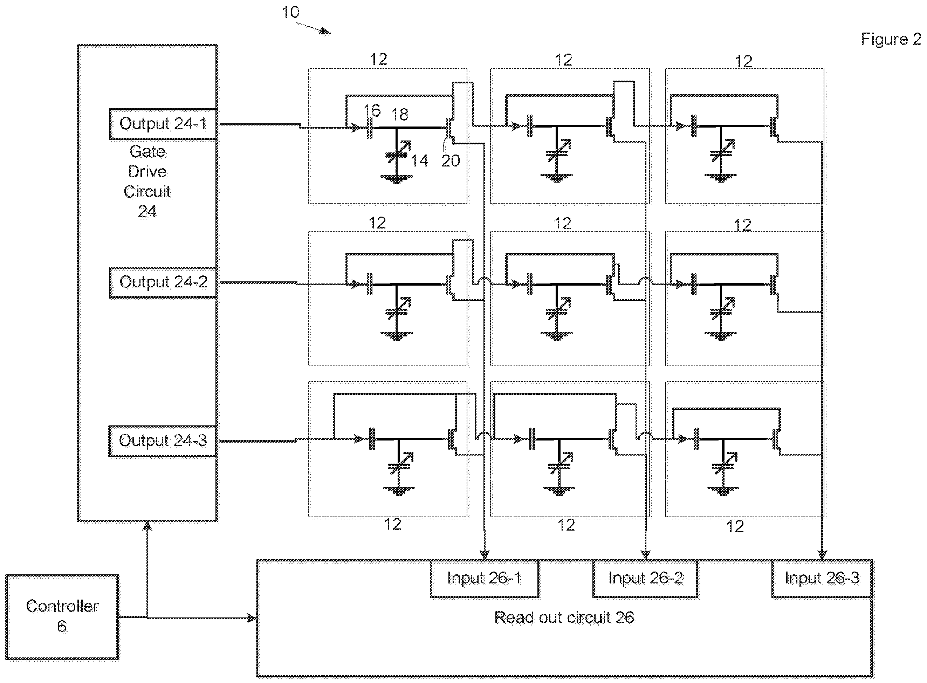

Figure 1 shows a sensor apparatus 1 in which the sensor array 10 of the present disclosure may be incorporated. Figure 2 illustrates a circuit diagram of one such sensor array 10. The description which follows shall refer to Figure 1 and Figure 2 together. It can be seen from an inspection of Figure 1 and Figure 2 that inset A of Figure 1 shows a detailed view of one pixel of this array 10.

The sensor array 10 comprises a plurality of touch sensitive pixels 12. Typically, other than in respect of its position in the array, each pixel 12 is identical to the others in the array 10. As illustrated, each pixel 12 comprises a capacitive sensing electrode 14 for accumulating a charge in response to proximity of the surface of a conductive object to be sensed. A reference capacitor 16 is connected between the capacitive sensing electrode 14 and a connection to a gate drive channel 24-1 of a gate drive circuit 24. Thus, a first plate of the reference capacitor 16 is connected to the gate drive channel 24-1, and a second plate of the reference capacitor 16 is connected to the capacitive sensing electrode 14.

Each pixel 12 may also comprise a sense VCI (voltage controlled impedance) 20 having a conduction path, and a control terminal (22; inset A, Figure 1) for controlling the impedance of the conduction path. The conduction path of the sense VCI 20 may connect the gate drive channel 24-1 to an output of the pixel 12. The control terminal 22 of the VCI is connected to the capacitive sensing electrode 14 and to the second plate of the reference capacitor 16. Thus, in response to a control voltage applied by the gate drive channel 24-1, the reference capacitor 16 and the capacitive sensing electrode 14 act as a capacitive potential divider.

The capacitance of the capacitive sensing electrode 14 depends on the proximity, to the capacitive sensing electrode 14, of a conductive surface of an object to be sensed. Thus, when a control voltage is applied to the first plate of the reference capacitor 16, the relative division of that voltage between that sensing electrode 14 and the reference capacitor 16 provides an indication of the proximity of the surface of that conductive object to the capacitive sensing electrode 14. This division of the control voltage provides an indicator voltage at the connection 18 between the reference capacitor 16 and the capacitive sensing electrode 14. This indicator voltage can be applied to the control terminal 22 of the sense VCI 20 to provide an output from the pixel 12 which indicates proximity of the conductive object.

Pixels may be positioned sufficiently close together so as to be able to resolve contours of the skin such as those associated with epidermal ridges, for example those present in a fingerprint, palmprint or other identifying surface of the body. It will be appreciated in the context of the present disclosure that contours of the skin may comprise ridges, and valleys between those ridges. During touch sensing, the ridges may be relatively closer to a sensing electrode than the "valleys" between those ridges. Accordingly, the capacitance of a sensing electrode adjacent a ridge will be higher than that of a sensing electrode which is adjacent a valley. The description which follows explains how systems can be provided in which sensors of sufficiently high resolution to perform fingerprint and other biometric touch sensing may be provided over larger areas than has previously been possible.

As shown in Figure 1 and Figure 2 in addition to the sensor array 10, such a sensor may also comprise a dielectric shield 8, a gate drive circuit 24, and a read out circuit 26. A connector 25 for connection to a host device may also be included. This may be provided by a multi-channel connector having a plurality of conductive lines. This may be flexible, and may comprise a connector such as a flexi, or flexi-rigid PCB, a ribbon cable or similar. The connector 25 may carry a host interface 27, such as a plug or socket, for connecting the conductive lines in the connector to signal channels of a host device in which the sensor apparatus 1 is to be included.

The host interface 27 is connected by the connector 25 to the read-out circuit 26. A controller (6;Figure 2) may be connected to the gate drive circuit 24 for operating the sensor array, and to the read-out circuit 26 for obtaining signals indicative of the self-capacitance of pixels of the sensor array 10.

The dielectric shield 8 is generally in the form of a sheet of an insulating material which may be transparent and flexible such as a polymer or glass. The dielectric shield 8 may be flexible, and may be curved. An 'active area' of this shield overlies the sensor array 10. In some embodiments, the VCIs and other pixel components are carried on a separate substrate, and the shield 8 overlies these components on their substrate. In other embodiments the shield 8 provides the substrate for these components.

The sensor array 10 may take any one of the variety of forms discussed herein. Different pixel designs may be used, typically however the pixels 12 comprise at least a capacitive sensing electrode 14, a reference capacitor 16, and at least a sense VCI 20.

The array illustrated in Figure 2 comprises a plurality of rows of pixels such as those illustrated in Figure 1. Also shown in Figure 2 is the gate drive circuit 24, the read out circuit 26, and a controller 6. The controller 6 is configured to provide a clock signal, e.g. a periodic trigger, to the gate drive circuit 24, and to the read-out circuit 26.

The gate drive circuit 24 comprises a plurality of gate drive channels 24-1, 24-2, 24-3, which it is operable to control separately, e.g. independently. Each such gate drive channel 24-1, 24-2, 24-3 comprises a voltage source arranged to provide a control voltage output. And each channel 24-1 is connected to a corresponding row of pixels 12 of the sensor array 10. In the arrangement shown in Figure 2 each gate drive channel 24-1, 24-2, 24-3 is connected to the first plate of the reference capacitor 16 in each pixel 12 of its row of the sensor array 10. During each clock cycle, the gate drive circuit 24 is configured to activate one of the gate drive channels 24-1, 24-2, 24-3 by applying a gate drive pulse to those pixels. Thus, over a series of cycles the channels (and hence the rows) are activated in sequence, and move from one step in this sequence to the next in response to the clock cycle from the controller 6.

The read-out circuit 26 comprises a plurality of input channels 26-1, 26-2, 26-3. Each input channel 26-1, 26-2, 26-3 is connected to a corresponding column of pixels 12 in the sensor array 10. To provide these connections, the conduction path of the sense VCI 20 in each pixel 12 is connected to the input channel 26-1 for the column.

Each input channel 26-1, 26-2, 26-3 of the read out circuit 26 may comprise an analogue front end (AFE) and an analogue-to-digital converter (ADC) for obtaining a digital signal from the column connected to that input channel 26-1. For example it may integrate the current applied to the input channel during the gate pulse to provide a measure of the current passed through the sense VCI 20 of the active pixel 12 in that column. The read out circuit 26 may convert this signal to digital data using the ADC. Furthermore, the analogue front end performs impedance matching, signal filtering and other signal conditioning and may also provide a virtual reference.

In the sensor array 10 shown in Figure 2, the conduction channel of the sense VCI 20 in each pixel connects the input channel of the read out circuit for that column to the gate drive channel for the pixel's row. In Figure 2, the gate drive channel for the row thus provides a reference input. Operation of the sense VCI 20 modulates this reference input to provide the pixel output. This output signal from a pixel indicates the charge stored on the capacitive sensing electrode 14 in response to that reference input relative to that stored on the reference capacitor.

Figure 1 includes a grid as a very schematic illustration of the rows and columns of pixels 12 which make up the array. Typically this will be a rectilinear grid, and typically the rows and columns will be evenly spaced. For example the pixels may be square. It will of course be appreciated that the grid shown in Figure 1 is not to scale. Typically the sensor array has a pixel spacing of at least 200 dots per inch, dpi (78 dots per cm). The pixel spacing may be at least 300 dpi (118 dots per cm), for example at least 500 dpi (196 dots per cm).

Operation of the sensor array 10 of Figure 2 will now be described.

On each cycle of operation, the gate drive circuit 24 and the read out circuit 26 each receive a clock signal from the controller 6.

In response to this clock signal, the gate drive circuit operates one of the gate drive channels to apply a control voltage to one of the rows of the array. In each pixel in the row, the control voltage from the gate drive channel is applied to the series connection of the reference capacitor 16 and the capacitive sensing electrode 14. The voltage at the connection 18 between the two provides an indicator voltage indicating the proximity of a conductive surface of an object to be sensed to the capacitive sensing electrode 14. This indicator voltage may be applied to the control terminal of the sense VCI 20 to control the impedance of the conduction path of the sense VCI 20. A current is thus provided through the conduction path of the sense VCI 20 from the gate drive to the input channel for the pixel's column. This current is determined by the gate drive voltage, and by the impedance of the conduction channel.

In response to the same clock signal, the read-out circuit 26 senses the pixel output signal at each input channel. This may be done by integrating the current received at each input of the read-out circuit 26 over the time period of the gate pulse. The signal at each input channel, such as a voltage obtained by integrating the current from the corresponding column of the array, may be digitised (e.g. using an ADC). Thus, for each gate pulse, the read-out circuit 26 obtains a set of digital signals, each signal corresponding to a column of the active row during that gate pulse. So the set of signals together represent the active row as a whole, and the output from each pixel being indicative of the charge stored on and/or the self-capacitance of the capacitive sensing electrode 14 in that pixel.

Following this same process, each of the gate-drive channels is activated in sequence. This drives the sense VCI 20 of each pixel connected to that channel into a conducting state for a selected time (typically the duration of one gate pulse). By activating the rows of the array in sequence the read out circuit, can scan the sensor array row-wise. Other pixel designs, other scan sequences, and other types of sensor array, may be used.

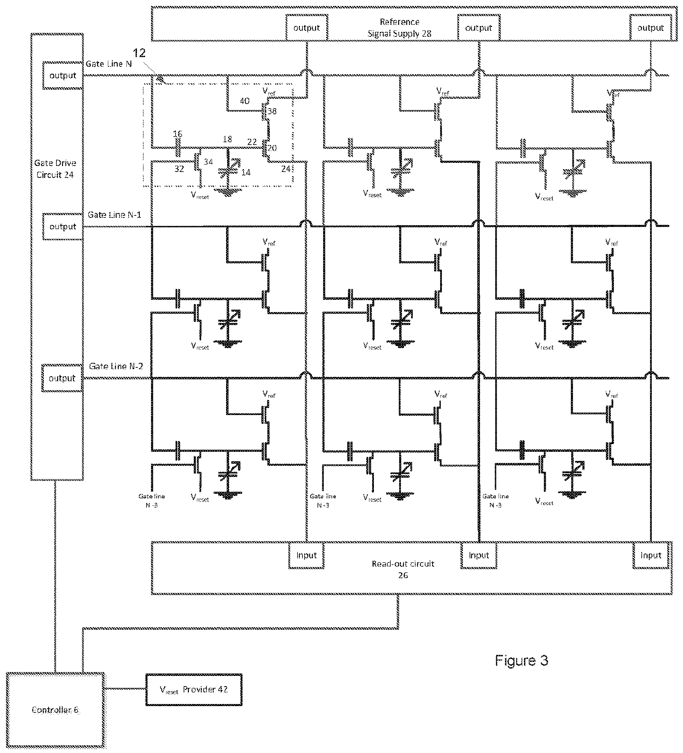

Figure 3 illustrates another sensor array which may be used in the apparatus illustrated in Figure 1.

Figure 3 shows a sensor array 10 comprising a plurality of pixels, and a reference signal supply 28 for supplying a reference signal to the pixels. This can avoid the need for the gate drive power supply also to provide the current necessary for the read-out signal.

Also shown in Figure 3 is the gate drive circuit 24, the read-out circuit 26, and the controller 6.

The sensor array 10 may also benefit from the inclusion of a reset circuit 32, 34 in each pixel. This may allow the control terminal 22 of the pixel to be pre-charged to a selected reset voltage whilst the pixel is inactive (e.g. while another row of the array is being activated by the application of a gate pulse to another, different, row of the array).

In these embodiments the sensor may also comprise a reset voltage provider 42 for providing a reset voltage to each of the pixels 12 of the array as described below. The reset voltage provider 42 may comprise voltage source circuitry, which may be configured to provide a controllable voltage, and may be connected to the controller 6 to enable the controller 6 to adjust and fix the reset voltage.

The reset voltage may be selected to tune the sensitivity of the pixel. In particular, the output current of the sense VCI 20 typically has a characteristic dependence on the indicator voltage at the control terminal 22 and its switch-on voltage. Thus the reset voltage may be chosen based on the switch-on voltage of the sense VCI 20. The characteristic may also comprise a linear region in which it may be preferable to operate.

The pixels illustrated in Figure 3 are similar to those illustrated in Figure 1 and Figure 2 in that each comprise a capacitive sensing electrode 14, and a reference capacitor 16 connected with a capacitive sensing electrode 14. The connection between these two capacitances provides an indicator voltage, which can for example be connected to the control terminal 22 of a sense VCI 20. In addition, the pixels of the sensor array illustrated in Figure 3 also comprise a further two VCIs 34, 38, and a connection to the reset voltage provider 42, and a connection to the reference signal supply 28.

As noted above, the sense VCI 20 is arranged substantially as described above with reference to Figure 1, in that its control terminal 22 is connected to the connection between the reference capacitor 16 and the capacitive sensing electrode 14. However, the conduction path of the sense VCI 20 is connected differently in Figure 3 than in Figure 1. In particular, the conduction channel of the select VCI 38 connects the conduction channel of the sense VCI 20 to the reference signal supply 28 which provides a voltage V_{ref}. Thus, the conduction channel of the sense VCI 20 is connected in series between the conduction channel of the select VCI 38 and the input of the read-out circuit for the column. The select VCI 38 therefore acts as a switch that, when open, connects the sense VCI 20 between, V_{ref}, the reference signal supply 28 and the input of the read-out circuit and, when closed, disconnects the sense VCI from the reference signal supply 28. In the interests of clarity, the connection between the conduction channel of the select VCI and V_{ref}, the output of the reference signal supply 28 is shown only in the top row of the array of pixels. The connection reference signal supply 28 in the lower rows of the array is indicated in the drawing using the label V_{ref}.

The select VCI 38 is therefore operable to inhibit the provision of signal from any inactive pixel to the input of the read-out circuit 26. This can help to ensure that signal is only received from active pixels (e.g. those in the row to which the gate drive pulse is being applied).

In an embodiment each column of pixels is virtually connected to a ground or reference voltage. As such there may be no voltage differences on each of the columns thereby minimising parasitic capacitance. Furthermore, the reference signal supply may apply a current-drive rather than a voltage-drive which further reduces any effect parasitic capacitance could have on the signal applied by the active pixels on the inputs of the read-out circuit 26.

The gate drive channel for the pixel row is connected to the first plate of the reference capacitor 16, and to the control terminal of a select VCI 38. As in the pixel illustrated in Figure 1, and Figure 2, the connection to the reference capacitor 16 and capacitor sensing electrode 14 means that the gate drive voltage is divided between the reference capacitor 16 and the capacitive sensing electrode 14 to provide the indicator voltage which controls the sense VCI 20. The connection to the control terminal 40 of the select VCI 38 however means that, when the pixel is not active, the conduction path of the sense VCI 20 is disconnected from the reference signal supply 28.

A control terminal 22 of the sense VCI 20 is connected to the second plate of the reference capacitor 16. The conduction path of the sense VCI 20 connects the reference signal supply 28 to the input of the read-out circuit 26 for the pixel's column.

A conduction path of the reset VCI 34 is connected between the second plate of the reference capacitor 16 and a voltage output of the reset voltage provider, for receiving the reset voltage. The control terminal 32 of the reset VCI 34 is connected to a reset signal provider, such as the gate drive channel of another row of the sensor array. This can enable the reset VCI 34 to discharge the reference capacitor 16 during activation of another row of the array (e.g. a row of the array which is activated on the gate pulse prior to the pixel's row) or to pre-charge the control terminal 22 of the sense VCI 20 to the reset voltage.

Operation of the sensor array of Figure 3 will now be described.

The gate drive circuit 24 and the read-out circuit 26 each receive a clock signal from the controller 6. In response to this clock signal, the gate drive circuit 24 activates a first gate drive channel of the gate drive circuit 24 to provide a gate pulse to a row of the array 10. A control voltage is thus applied to the control terminal of the select VCI 38 of the pixels in the first row (the active row during this gate pulse).

The control voltage is also applied to the control terminal of the reset VCI 34 of the pixels in a second row (inactive during this gate pulse).

In the first row (the active row), the conduction channel of the select VCI 38 is switched into a conducting state by the control voltage (e.g. that which is provided by the gate pulse). The conduction channel of the select VCI 38 thus connects the conduction channel of the sense VCI 20 to the reference signal supply 28.

The control voltage is also applied to the first plate of the reference capacitor 16. The relative division of voltage between the sensing electrode 14 and the reference capacitor 16 provides an indicator voltage at the connection between the reference capacitor 16 and the capacitive sensing electrode 14 as described above with reference to Figure 1 and Figure 2. The indicator voltage is applied to the control terminal 22 of the sense VCI 20 to control the impedance of the conduction channel of the sense VCI 20. Thus, the sense VCI 20 connects the reference signal supply 28 to the input channel of the read-out circuit 26 for that column, and presents an impedance between the two which indicates the capacitance of the capacitive sensing electrode 14. Please note, the reference signal supply may be provided by a constant voltage current supply.

A current is thus provided through the conduction path of the sense VCI 20 from the reference signal supply 28 to the input channel of the read-out circuit 26 for the pixel's column. This current is determined by the voltage of the reference signal supply and by the impedance of the conduction channel of the sense VCI.

In response to the same clock signal from the controller 6, the read-out circuit 26 senses the pixel output signal at each input channel (e.g. by integrating the current provided to each input channel), and digitises this signal. The integration time of the read-out circuit 26 may match the duration of the gate pulse.

Thus, in each clock cycle, the read-out 26 circuit obtains a set of digital signals, each signal corresponding to the signals sensed from each column of the active row during the gate pulse. The output from each pixel 12 in the row (each channel during that gate pulse) being indicative of the charge stored on the capacitive sensing electrode in that pixel.

In the second (inactive) row the control voltage is applied to the control terminal 32 of the reset VCI 34. This causes the reset VCI 34 of the pixels in the inactive row to connect the second plate of their reference capacitors 16 to a reset voltage provided by the reset voltage provider. This may discharge (e.g. at least partially remove) charge accumulated on the pixels of the inactive row, or it may charge them to the reset voltage, before they are next activated in a subsequent gate pulse. This reset voltage may be selected to tune the sensitivity of the pixels.

At the boundaries of the pixel array, where an N-1 gate line is not available, a dummy signal may be used to provide the control signal to the reset VCI. The gate drive circuit 24 may provide the dummy signal. This may be provided by a gate drive channel which is only connected to the rest VCIs of a row at the boundary of the array, but not to any sense or select VCIs.

As illustrated in Figure 3, the reset VCI 34 of the pixels may be connected to the gate drive circuit so that each row is discharged in this way by the gate pulse which activates the immediately preceding row, which may be an adjacent row of the array.

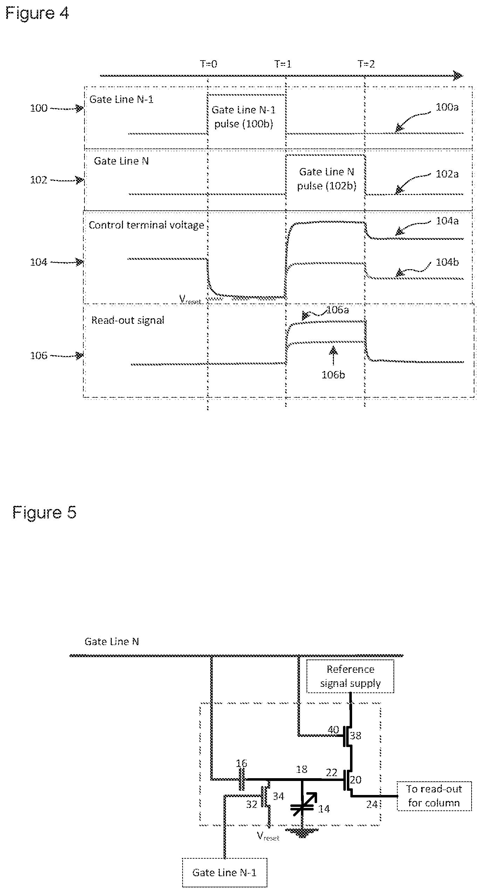

Figure 4 shows a signal timing diagram for a pixel in row N of the sensor array of Figure 3 in operation.

The signal timing diagram of Figure 4 comprises four separate plots (100, 102, 104, 106) of signal values against a common time axis.

The first plot 100 is indicative of the control voltage 100a applied to gate line N-1 in response to gate pulse N-1 100b. The second plot 102 is indicative of the control voltage 102a applied to gate line N in response to gate pulse N 102b, the third plot 104 indicates the control terminal 22 voltage of a pixel sensing a conductive object at two different distances, (104a) and (104b) from capacitive sensing electrode 14, and the fourth lowermost plot 106 indicates the read-out signals (106a and 106b) from the pixel in of plot 104 applied to the input of the read-out circuit26.

The time axis of Figure 4 has three gradations T₀,T₁ and T₂ indicating different points in time. The interval between T₀ and T₁ indicates the duration of gate pulse N-1 and the interval between T₁ and T₂ indicates the duration of gate pulse N.

The behaviour of the plots of Figure 4 whilst the sensor array is in operation will now be discussed.

At T₀ a control voltage 100 produced in response to the gate pulse N-1 100b is applied from gate line N-1 to the control terminals of the reset VCIs 34 of the pixels in row N. This switches the reset VCIs 34 on and therefore a conduction path is opened through the reset VCIs 34 between the control terminals 22 of the sense VCIs 20 and the voltage output of the reset voltage provider. As a result, the reset voltage is applied to the control terminal 22 of the sense VCI 20 of the pixel as can be seen in the plots 104a and 104b between T₀ and T₁ of the voltage of the control terminal 22 of the sense VCI 20.

As mentioned in the description above the reset voltage may be selected to tune the sensitivity of the pixels in the array. In particular, the output current of the sense VCIs 20 typically have a characteristic dependence on the indicator voltage at the control terminal 22 and its switch on voltage. Thus the reset voltage may be chosen based on the switch on voltage of the sense VCI 20. The characteristic may also comprise a linear region in which it may be preferable to operate.

At T₁, after the gate pulse N-1 has finished 100b, a gate pulse N 102b from gate line N causes the gate drive circuit 24 to apply a control voltage 102a to the first electrodes of the reference capacitors 16 and to the control terminals 40 of the select VCIs 38 of the pixels in row N.

As a result of the application of the control voltage 102 to the control terminals 40 of the select VCIs 38 a conduction path is opened between the reference signal supply 28 and the sense VCIs 20 of the pixels of row N.

When a conductive surface is in sufficient proximity to the capacitive sensing electrode 14 of a pixel in row N, as is the case in Figure 4, an indicator voltage 104a, dependent on the relative division of voltage between the sensing electrode 14 and the reference capacitor 16, is produced. The indicator voltage produced by the capacitive sensing electrode and reference capacitor is applied to the control terminal 22 of the sense VCI 20. A conduction path is thereby opened between the reference signal supply 28 and the read-out circuit 26.

As a result, signals such as those shown in 106 are applied to the corresponding input of the read-out circuit 26. The magnitude of the signal will depend on the proximity of the conductive surface.

The example shown in Figure 4 overlays two signals (106a and 106b) generated by a conductive object positioned at two different distances from the capacitive sensing electrode 14 of a pixel.

The two different positions of the conductive object result in two different capacitances of the sensing electrode (e.g. because the dermis of the finger provides a second "plate" of a capacitor, the first "plate" of which is provided by the sensing electrode 14). The indicator voltages (104a and 104b) are applied to the control terminal 22 of the sense VCI 20 of the pixel. Therefore the impedance of the conduction path of the sense VCI 20 is different for the two positions of the conductive surface.

The signal applied to the input of the read-out circuit 26 is dependent on the impedance of the sense VCI 20 and is therefore different for the conductive surface at two different distances from the capacitive sensing electrode 14.

This is exemplified in the control terminal voltage signals 22 (104a and 104b) and read out signal profiles (106a and 106b) shown in Figure 4.

At T₂ the gate line pulse N 102b finishes and the gate drive circuit ceases to apply a control voltage 102a to the pixels in row N. The control voltage 102 is no longer being applied to the control terminals of the select VCIs 38 and as a result the select VCIs of row N turn off.

The conduction paths through the select VCIs of the pixels in row N therefore close and a signal (106a and 106b) is no longer applied by the pixel to the input of the read-out circuit.

It can be seen that some residual charge on the sensing electrode may remain after the gate pulse for line N 102bhas finished. It will be appreciated in the context of the present disclosure that the select VCI 38 may act to prevent such residual charge operating the sense VCI 20 and so giving rise to spurious signal from inactive rows.

Different pixel designs may be used in arrangements such as that described with reference to Figure 3.

Figure 5 illustrates a circuit diagram of the sensor pixel 12 that is illustrated in the array of Figure 3. The pixel 12 however is shown in isolation in the interests of clarity.

It can be seen that the pixel 12 comprises a reference capacitor 16, a capacitive sensing electrode 14, a sense VCI 20, a select VCI 38 and a reset VCI 34.

The pixel 12 of Figure 5 is similar to that shown in Figure 1 and described above, in that a connection between the reference capacitor 16 and the capacitive sensing electrode 14 provides an indictor voltage which may be connected to the control terminal of the sense VCI 20.

However, the pixel 12 of Figure 5 differs from that of Figure 1 in that it comprises a select VCI 38 and a reset VCI 34.

The conduction path of the select VCI 38 is connected between the conduction channel of the sense VCI 20 and a reference signal supply. Thus the sense VCI 20 is connected in series between the select VCI 38 and an input of a read-out circuit 26. A gate line input of the pixel is connected to the control terminal 40 of the select VCI 38.

The conduction path of the reset VCI 34 is connected between the second plate of the reference capacitor 16 and a reset voltage provider. The control terminal of the reset VCI 34 is connected to a reset signal provider input of the pixel, when the pixel is assembled into an array this may, for example, be a connection with a gate line of another row of pixels in the array.

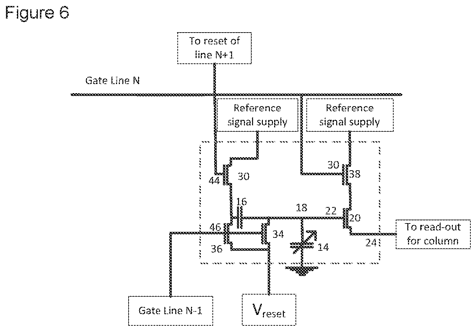

Figure 6 illustrates yet a further example of a pixel suitable for use in an array such as that illustrated in Figure 3. This pixel is identical to that described in Figure 4 other than in that it comprises a gate line VCI 30, and a second reset VCI 36.

The control terminal 44 of the gate line VCI 30 is connected to the gate drive channel for its row of the array. The conduction path of the gate line VCI 30 is connected between the reference signal supply 28 and a first plate of the reference capacitor 16. Thus, operation of the gate line VCI 30 by the gate drive circuit 24 can connect the series connection of the reference capacitor 16 and capacitive sensing electrode 14 to the reference signal supply 28. And, when the gate line VCI 30 is switched off the pixel disconnects from the reference signal supply 28.

In addition, the gate line signal need not supply the current to charge the array for readout.

As with the pixel of Figure 5, the reset circuit of the pixel shown in Figure 6 comprises the reset VCI 34 connected between the second plate of the reference capacitor 16 and a reset voltage provider 42, and also comprises a reset VCI 36 connected between the first plate of the reference capacitor 16 and the reset voltage provider. The control terminal 32 of the reset VCI34 and the control terminal 46 of the reset VCI 36 are connected to a reset signal provider, such as the gate drive channel of another row of the sensor array as described above.

It will be appreciated in the context of the present disclosure that other reset circuits may be used. For example the conduction path of the reset VCI 34 may connect the first plate of the reference capacitor to its second plate (e.g. to short circuit the reference capacitor 16).

Operation of the pixel 12 shown in Figure 6 in the array of Figure 3 is similar to that of the operation of the pixel shown in Figure 5 and described above. However in addition to operating the control terminal of the select VCI 38, the control voltage also operates the gate line VCI 30 to connect the first plate of the reference capacitor 16 to the reference signal supply 28. This reference signal is used to provide an indicator voltage at the connection between the reference capacitor 16 and the capacitive sensing electrode 14 as described above with reference to Figure 1 and Figure 2. The indicator voltage is applied to the control terminal of the sense VCI 20, to control the impedance of the conduction channel of the sense VCI 20, which when a control voltage is applied to select VCI 38 connects the reference signal supply 28 to the input channel of the read out circuit for that column.

In addition, in response to a reset signal from a reset signal provider (such as the gate drive channel of another row of the sensor array as described above)to the control terminals of the reset VCI 36 and reset VCI 34 a conduction path is opened between the reference capacitor 16 and the reset voltage provider. This causes the reset voltage to be applied to both electrodes of the reference capacitor 16 and thus the voltage across the reference capacitor 16 to be zero.

The reset voltage may be selected based on the thickness of the dielectric shield and/or the dielectric constant of the shield. For example, the reset voltage may be chosen to ensure that the range of capacitance changes associated with features of an object to be sensed (e.g. the contours of human skin) provide changes in indicator voltages from the capacitive potential divider 14, 16, that are sufficient to operate the sense VCI in a measurably different way. For example, the reset voltage may be chosen based on a threshold voltage of the sense VCI and based on the thickness of the dielectric shield and/or the dielectric constant of the shield so that the ridges and valleys of the contours of the skin both cause operation of the sense VCI in a linear region of its current voltage characteristic.

This may be desirable as the output current of the conduction path of the sense VCI 20 is dependent on the indicator voltage applied to the control terminal 22 and furthermore the change in the output current of the sense VCI 20 for a given change in control terminal voltage 22 is dependent on the value of the voltage applied to the control terminal 22.

It may be advantageous to set the reset voltage so that the control terminal 22 voltage of the sense VCI is in a voltage range where the VCI's output current varies linearly with control terminal 22 voltage. This is particularly true where the select VCI is present. It is also possible to select the reset voltage based on a threshold voltage of the sense VCI eg so that in a quiescent state, the sense VCI is at the threshold.

The embodiments described herein typically comprise one or more voltage controlled impedance (VCI). Each such VCI has a control terminal, and a conduction path the impedance of which can be controlled by a voltage applied to its control terminal. Examples of voltage controlled impedances include transistors such as thin film transistors (TFTs). It will also be appreciated that when implemented into the sensor as a means of achieving voltage controlled impedances thin film transistors would act as transconduction gates wherein the output current (I_{drain-source}) of the TFT would be dependent on the voltage across the gate and source (V_{gate-source}) of the TFT.

The dielectric shield may comprise a sheet or layer of insulating material such as glass or plastic. The insulating material of the dielectric shield described herein may be selected based on one or more of the following properties: surface roughness, transparency, chemical inertia, mechanical stiffness and robustness, dielectric constant; thermal behaviour and ease of manufacture. Suitable glass substrates include but are not limited to: Soda lime, borasilicate and SiO₂. Suitable polymer substrates include but are not limited to Poly Imide (PI), Polyethylene terephthalate (PET), polyethylene naphthalate (PEN).

It will be appreciated in the context of the present disclosure that the sensor apparatus may be designed to match certain timings.

The read-out of the pixel array performed by the read-out circuit may be executed on a frame basis, wherein each row of the pixels is read-out sequentially using a dedicated row time. Such that within a row time, all the corresponding pixels of that row are read-out.

Such a read-out is similar to TFT display technology. However the present case relates to pixel-reading of the sensor array rather than the pixel-writing of a TFT display.

The collection of all rows and related timing, may define the frame time of the sensor apparatus. For example a row time of 25µsec, with a total of 100 rows, would result in a frame time of 2.5msec i.e 25µsec x 100msecs.

Other timings and read-out sequences may also be appropriate. For example in the case of multiplexer circuits, a multiple number of conversions may have to be executed within a single gate line time.

The embodiments disclosed herein describe the provision of a reset voltage to each of the pixels in the pixel array. The pixels in the pixel array may receive the same reset voltage wherein the reset voltage is chosen in the manner described previously.

It will be appreciated from the discussion above that the embodiments shown in the Figures are merely exemplary, and include features which may be generalised, removed or replaced as described herein and as set out in the claims. With reference to the drawings in general, it will be appreciated that schematic functional block diagrams are used to indicate functionality of systems and apparatus described herein. It will be appreciated however that the functionality need not be divided in this way, and should not be taken to imply any particular structure of hardware other than that described and claimed below. The function of one or more of the elements shown in the drawings may be further subdivided, and/or distributed throughout apparatus of the disclosure. In some embodiments the function of one or more elements shown in the drawings may be integrated into a single functional unit.

For example, the use of a controller to provide a clock signal has been mentioned. However, it will be appreciated in the context of the present disclosure that the controller may be part of the gate drive circuit and/or the gate pulse signal which is described herein may be used instead of the clock signal. For example, operation of the read-out circuit and the gate drive circuit may by synchronised using the gate pulses. For example the integration period of each input channel of the read out circuit may be controlled by the gate pulse.

In some examples the functionality of the controller may be provided by a general purpose processor, which may be configured to perform a method according to any one of those described herein. In some examples the controller may comprise digital logic, such as field programmable gate arrays, FPGA, application specific integrated circuits, ASIC, a digital signal processor, DSP, or by any other appropriate hardware. In some examples, one or more memory elements can store data and/or program instructions used to implement the operations described herein. Embodiments of the disclosure provide tangible, non-transitory storage media comprising program instructions operable to program a processor to perform any one or more of the methods described and/or claimed herein and/or to provide data processing apparatus as described and/or claimed herein. The controller may comprise an analogue control circuit which provides at least a part of this control functionality. An embodiment provides an analogue control circuit configured to perform any one or more of the control methods described herein.

The above embodiments are to be understood as illustrative examples. Further embodiments are envisaged. It is to be understood that any feature described in relation to any one embodiment may be used alone, or in combination with other features described, and may also be used in combination with one or more features of any other of the embodiments, or any combination of any other of the embodiments. Furthermore, modifications not described above may also be employed provided that they are encompassed in the scope of the invention, which is defined in the accompanying claims.

## Claims

1. A sensor array (10) comprising a plurality of touch sensitive pixels (12), each pixel (12) comprising:
a capacitive sensing electrode (14) for accumulating a charge in response to proximity of a conductive object to be sensed;
a reference capacitor (16) connected in series with the capacitive sensing electrode (14) so that, in response to a control voltage, an indicator voltage is provided at the connection (18) between the reference capacitor (16) and the capacitive sensing electrode (14) to indicate the proximity of the conductive object to be sensed,
a sense voltage controlled impedance, VCI, (20) having a control terminal (22) connected so that the impedance of the sense VCI (20) is controlled by the indicator voltage;
**characterised in that**
each pixel (12) comprises a reset circuit for setting the control terminal (22) of the sense VCI (20) to a reset voltage selected to tune the sensitivity of the pixels (10); and
wherein the reset voltage is selected based on a linear region of operation of the sense VCI (20).

2. The sensor array (10) of claim 1 wherein a control terminal (32) of the reset circuit is connected to another pixel (12) of the sensor (10) for receiving a reset signal.

3. The sensor array (10) of any preceding claim, wherein the reset circuit comprises a reset VCI (34), wherein a conduction path of the reset VCI (34) is connected between a second plate of the reference capacitor (16) and a reset voltage (Vᵣₑₛₑₜ).

4. The sensor array (10) of any preceding claim wherein the reset voltage (Vᵣₑₛₑₜ) is provided by a reset voltage provider and is based on at least one of:
a switch on voltage of the sense VCI (20); and
a thickness and/or dielectric constant of a dielectric touch shield of the sensor (10).

5. The sensor array (10) of any preceding claim, wherein a conduction path of the sense VCI (20) connects a reference signal supply (28) to an input of a readout circuit (26).

6. The sensor array (10) of claim 5, comprising a select VCI (38) having a conduction path connected in series between the conduction path of the sense VCI (20) and the reference signal supply (28).

7. The sensor array (10) of claim 6, wherein a control terminal (40) of the select VCI (38) is connected to the control voltage.

8. The sensor array (10) of any preceding claim, wherein a first plate of the reference capacitor (16) is connected to the control voltage.

9. The sensor array (10) of any preceding claim, wherein the voltage controlled impedances comprise thin film transistors, TFTs.

10. A method of operating a sensor array (10) comprising a plurality of touch sensitive pixels (12), the method comprising:
applying a control voltage to a reference capacitor (16) of a pixel (12) of the sensor (10) to charge the reference capacitor (16) and a capacitive sensing electrode (14), wherein the reference capacitor (16) and the capacitive sensing electrode (14) together provide, in response to the control voltage, an indicator voltage indicative of the proximity of a conductive object to be sensed by the pixel (12);
using the indicator voltage to control the impedance of a conduction path of a sense voltage controlled impedance, VCI, (20) connected to an input channel of a readout circuit (26); and
resetting the reference capacitor (16) prior to a subsequent application of the control voltage, **characterised in that**
resetting comprises setting the control terminal (22) of the sense VCI (20) to a reset voltage (Vᵣₑₛₑₜ) selected to tune the sensitivity of the pixels (12), and wherein the reset voltage (Vᵣₑₛₑₜ) is selected based on a linear region of operation of the sense VCI (20).

11. The method of claim 10, further comprising applying the control voltage to a control terminal (40) of a select VCI (38) to connect the conduction path of the sense VCI (20) to a reference signal supply.

12. A sensor array (10) comprising a plurality of touch sensitive pixels (12), each pixel (12) comprising:
a capacitive sensing electrode (14) for accumulating a charge in response to proximity of a conductive object to be sensed;
a reference capacitor (16) connected in series with the capacitive sensing electrode (14) so that, in response to a control voltage, an indicator voltage is provided at the connection (18) between the reference capacitor (16) and the capacitive sensing electrode (14) to indicate the proximity of the conductive object to be sensed;
a sense voltage-controlled impedance, VCI, (20) having a control terminal (22) connected so that the impedance of the sense VCI (20) is controlled by the indicator voltage,
**characterised in that**
a conduction path of the sense VCI (20) connects a reference signal supply (28) to an input of a readout circuit (26); and
a select VCI (38) having a conduction path connected in series between the conduction path of the sense VCI (20) and the reference signal supply (28).

13. The sensor array (10) of claim 12, wherein each pixel (12) comprises a reset circuit for setting the control terminal (22) of the sense VCI (20) to a reset voltage (Vᵣₑₛₑₜ) selected to tune the sensitivity of the pixel (12).

14. The sensor array (10) of claim 13, wherein the reset circuit comprises a reset VCI (34), wherein a conduction path of the reset VCI (34) is connected between a second plate of the reference capacitor (16) and a reset voltage (Vᵣₑₛₑₜ).

15. A method of operating a sensor array (10) comprising a plurality of touch sensitive pixels (12), the method comprising:
applying a control voltage to a reference capacitor (16) of a pixel (12) of the sensor to charge the reference capacitor (16) and a capacitive sensing electrode (14), wherein the reference capacitor (16) and the capacitive sensing electrode (14) together provide, in response to the control voltage, an indicator voltage indicative of the proximity of a conductive object to be sensed by the pixel (12);
using the indicator voltage to control the impedance of a conduction path of a sense voltage-controlled impedance, VCI, (20) connected to an input channel of a readout circuit (26); and
operating a select VCI (38), **characterised by**
having a conduction path connected in series between the conduction path of the sense VCI (20) and a reference signal supply (28), to connect a reference signal supply (28) to the input channel of the readout circuit (26) via the conduction path of the sense VCI (20).

## Patentansprüche

1. Sensorarray (10), umfassend eine Vielzahl von berührungsempfindlichen Pixeln (12), wobei jedes Pixel (12) Folgendes umfasst:
eine kapazitive Abtastelektrode (14) zum Akkumulieren einer Ladung als Reaktion auf die Nähe eines abzutastenden leitfähigen Objekts;
einen Referenzkondensator (16), der mit der kapazitiven Abtastelektrode (14) derart in Reihe angeschlossen ist, dass als Reaktion auf eine Steuerspannung eine Angabespannung am Anschluss (18) zwischen dem Referenzkondensator (16) und der kapazitiven Abtastelektrode (14) bereitgestellt wird, um die Nähe eines abzutastenden leitfähigen Objekts anzugeben,
eine spannungsgesteuerte Abtastimpedanz, VCI, (20) mit einer Steuerklemme (22), die derart angeschlossen ist, dass die Impedanz der Abtast-VCI (20) durch die Angabespannung gesteuert wird;
**dadurch gekennzeichnet, dass** jedes Pixel (12) eine Rücksetzschaltung umfasst, um die Steuerklemme (22) der Abtast-VCI (20) auf eine Rücksetzspannung einzustellen, die dazu ausgewählt wird, die Empfindlichkeit der Pixel (10) abzustimmen; und
wobei die Rücksetzspannung basierend auf einer linearen Betriebsregion der Abtast-VCI (20) ausgewählt wird.

2. Sensorarray (10) nach Anspruch 1, wobei eine Steuerklemme (32) der Rücksetzschaltung an ein anderes Pixel (12) des Sensors (10) angeschlossen ist, um ein Rücksetzsignal zu empfangen.

3. Sensoranordnung (10) nach einem der vorhergehenden Ansprüche, wobei die Rücksetzschaltung eine Rücksetz-VCI (34) umfasst, wobei ein Leitungspfad der Rücksetz-VCI (34) zwischen einer zweiten Platte des Referenzkondensators (16) und einer Rücksetzspannung (V_{Rücksetz}) angeschlossen ist.

4. Sensorarray (10) nach einem der vorhergehenden Ansprüche, wobei die Rücksetzspannung (V_{Rücksetz}) von einem Rücksetzspannungsgeber bereitgestellt wird und auf mindestens einem von Folgendem basiert:
einer Einschaltspannung der Abtast-VCI (20); und
einer Dicke und/oder einer Dielektrizitätskonstante einer dielektrischen Berührungsabschirmung des Sensors (10).

5. Sensorarray (10) nach einem der vorhergehenden Ansprüche, wobei ein Leitungspfad der Abtast-VCI (20) eine Referenzsignalversorgung (28) an einen Eingang einer Ausleseschaltung (26) anschließt.

6. Sensorarray (10) nach Anspruch 5, umfassend eine Auswahl-VCI (38) mit einem Leitungspfad, der in Reihe zwischen dem Leitungspfad der Abtast-VCI (20) und der Referenzsignalversorgung (28) angeschlossen ist.

7. Sensorarray (10) nach Anspruch 6, wobei eine Steuerklemme (40) der Auswahl-VCI (38) an die Steuerspannung angeschlossen ist.

8. Sensorarray (10) nach einem der vorhergehenden Ansprüche, wobei eine erste Platte des Referenzkondensators (16) an die Steuerspannung angeschlossen ist.

9. Sensorarray (10) nach einem der vorhergehenden Ansprüche, wobei die spannungsgesteuerten Impedanzen Dünnschichttransistoren, TFTs, umfassen.

10. Verfahren zum Betreiben eines Sensorarrays (10), umfassend eine Vielzahl von berührungsempfindlichen Pixeln (12), wobei das Verfahren Folgendes umfasst:
Anlegen einer Steuerspannung an einen Referenzkondensator (16) eines Pixels (12) des Sensors (10), um den Referenzkondensator (16) und eine kapazitive Abtastelektrode (14) aufzuladen, wobei der Referenzkondensator (16) und die kapazitive Abtastelektrode (14) gemeinsam als Reaktion auf die Steuerspannung eine Angabespannung bereitstellen, die die Nähe eines durch das Pixel (12) abzutastenden leitfähigen Objekts angibt;
Verwenden der Angabespannung, um die Impedanz eines Leitungspfades einer spannungsgesteuerten Abtastimpedanz, VCI, (20) zu steuern, die an einen Eingangskanal einer Ausleseschaltung (26) angeschlossen ist; und
Zurücksetzen des Referenzkondensators (16) vor einer anschließenden Anlegung der Steuerspannung, **dadurch gekennzeichnet, dass** das Zurücksetzen das Einstellen der Steuerklemme (22) der Abtast-VCI (20) auf eine Rücksetzspannung (V_{Rücksetz}) umfasst, die dazu ausgewählt wird, die Empfindlichkeit der Pixel (12) abzustimmen, und wobei die Rücksetzspannung (V_{Rücksetz}) basierend auf einer linearen Betriebsregion der Abtast-VCI (20) ausgewählt wird.

11. Verfahren nach Anspruch 10, ferner umfassend das Anlegen der Steuerspannung an eine Steuerklemme (40) einer Auswahl-VCI (38), um den Leitungspfad der Abtast-VCI (20) an eine Referenzsignalversorgung anzuschließen.

12. Sensorarray (10), umfassend eine Vielzahl von berührungsempfindlichen Pixeln (12), wobei jedes Pixel (12) Folgendes umfasst:
eine kapazitive Abtastelektrode (14) zum Akkumulieren einer Ladung als Reaktion auf die Nähe eines abzutastenden leitfähigen Objekts;
einen Referenzkondensator (16), der mit der kapazitiven Abtastelektrode (14) derart in Reihe angeschlossen ist, dass als Reaktion auf eine Steuerspannung eine Angabespannung am Anschluss (18) zwischen dem Referenzkondensator (16) und der kapazitiven Abtastelektrode (14) bereitgestellt wird, um die Nähe eines abzutastenden leitfähigen Objekts anzugeben;
eine spannungsgesteuerte Abtastimpedanz, VCI, (20) mit einer Steuerklemme (22), die derart angeschlossen ist, dass die Impedanz der Abtast-VCI (20) durch die Angabespannung gesteuert wird,
**dadurch gekennzeichnet, dass** ein Leitungspfad der Abtast-VCI (20) eine Referenzsignalversorgung (28) an einen Eingang einer Ausleseschaltung (26) anschließt; und
eine Auswahl-VCI (38) mit einem Leitungspfad, der in Reihe zwischen dem Leitungspfad der Abtast-VCI (20) und der Referenzsignalversorgung (28) angeschlossen ist.

13. Sensorarray (10) nach Anspruch 12, wobei jedes Pixel (12) eine Rücksetzschaltung umfasst, um die Steuerklemme (22) der Abtast-VCI (20) auf eine Rücksetzspannung (V_{Rücksetz}) einzustellen, die dazu ausgewählt wird, die Empfindlichkeit der Pixel (12) abzustimmen.

14. Sensoranordnung (10) nach Anspruch 13, wobei die Rücksetzschaltung eine Rücksetz-VCI (34) umfasst, wobei ein Leitungspfad der Rücksetz-VCI (34) zwischen einer zweiten Platte des Referenzkondensators (16) und einer Rücksetzspannung (V_{Rücksetz}) angeschlossen ist.

15. Verfahren zum Betreiben eines Sensorarrays (10), umfassend eine Vielzahl von berührungsempfindlichen Pixeln (12), wobei das Verfahren Folgendes umfasst:
Anlegen einer Steuerspannung an einen Referenzkondensator (16) eines Pixels (12) des Sensors, um den Referenzkondensator (16) und eine kapazitive Abtastelektrode (14) aufzuladen, wobei der Referenzkondensator (16) und die kapazitive Abtastelektrode (14) gemeinsam als Reaktion auf die Steuerspannung eine Angabespannung bereitstellen, die die Nähe eines durch das Pixel (12) abzutastenden leitfähigen Objekts angibt;
Verwenden der Angabespannung, um die Impedanz eines Leitungspfades einer spannungsgesteuerten Abtastimpedanz, VCI, (20) zu steuern, die an einen Eingangskanal einer Ausleseschaltung (26) angeschlossen ist; und
Betreiben einer Auswahl-VCI (38), die **dadurch gekennzeichnet ist, dass** sie einen Leitungspfad aufweist, der in Reihe zwischen dem Leitungspfad der Abtast-VCI (20) und einer Referenzsignalversorgung (28) angeschlossen ist, um eine Referenzsignalversorgung (28) über den Leitungspfad der Abtast-VCI (20) mit dem Eingangskanal der Ausleseschaltung (26) anzuschließen.

## Revendications

1. Réseau de capteurs (10) comprenant une pluralité de pixels sensibles au toucher (12), chaque pixel (12) comprenant :
une électrode de détection capacitive (14) pour accumuler une charge en réponse à la proximité d'un objet conducteur à détecter ;
un condensateur de référence (16) connecté en série à l'électrode de détection capacitive (14) de telle sorte que, en réponse à une tension de commande, une tension indicatrice soit fournie au niveau de la connexion (18) entre le condensateur de référence (16) et l'électrode de détection capacitive (14) pour indiquer la proximité de l'objet conducteur à détecter,
une impédance commandée en tension de détection (VCI) (20) comportant une borne de commande (22) connectée de telle sorte que l'impédance de la VCI de détection (20) soit commandée par la tension indicatrice ;
le réseau de capteurs étant **caractérisé en ce que** chaque pixel (12) comprend un circuit de réinitialisation pour fixer la borne de commande (22) de la VCI de détection (20) à une tension de réinitialisation sélectionnée pour accorder la sensibilité des pixels (10) ; et
la tension de réinitialisation étant sélectionnée sur la base d'une région linéaire de fonctionnement de la VCI de détection (20).

2. Réseau de capteurs (10) selon la revendication 1, une borne de commande (32) du circuit de réinitialisation étant connectée à un autre pixel (12) du capteur (10) pour recevoir un signal de réinitialisation.

3. Réseau de capteurs (10) selon l'une quelconque des revendications précédentes, le circuit de réinitialisation comprenant une VCI de réinitialisation (34), un chemin de conduction de la VCI de réinitialisation (34) étant connecté entre une seconde plaque du condensateur de référence (16) et une tension de réinitialisation (Vᵣₑₛₑₜ).

4. Réseau de capteurs (10) selon l'une quelconque des revendications précédentes, la tension de réinitialisation (Vᵣₑₛₑₜ) étant fournie par un fournisseur de tension de réinitialisation et étant basée sur au moins un élément parmi :
une tension d'activation de la VCI de détection (20) ; et
une épaisseur et/ou une constante diélectrique d'un blindage tactile diélectrique du capteur (10).

5. Réseau de capteurs (10) selon l'une quelconque des revendications précédentes, un chemin de conduction de la VCI de détection (20) connectant une alimentation en signal de référence (28) à une entrée d'un circuit de lecture (26).

6. Réseau de capteurs (10) selon la revendication 5, comprenant une VCI de sélection (38) comportant un chemin de conduction connecté en série entre le chemin de conduction de la VCI de détection (20) et l'alimentation en signal de référence (28).

7. Réseau de capteurs (10) selon la revendication 6, une borne de commande (40) de la VCI de sélection (38) étant connectée à la tension de commande.

8. Réseau de capteurs (10) selon l'une quelconque des revendications précédentes, une première plaque du condensateur de référence (16) étant connectée à la tension de commande.

9. Réseau de capteurs (10) selon l'une quelconque des revendications précédentes, les impédances commandées en tension comprenant des transistors à couches minces (TFT).

10. Procédé de fonctionnement d'un réseau de capteurs (10) comprenant une pluralité de pixels sensibles au toucher (12), le procédé consistant à :
appliquer une tension de commande à un condensateur de référence (16) d'un pixel (12) du capteur (10) pour charger le condensateur de référence (16) et une électrode de détection capacitive (14), le condensateur de référence (16) et l'électrode de détection capacitive (14) fournissant ensemble, en réponse à la tension de commande, une tension indicatrice indiquant la proximité d'un objet conducteur à détecter par le pixel (12) ;
utiliser la tension indicatrice pour commander l'impédance d'un chemin de conduction d'une impédance commandée en tension de détection (VCI) (20) connectée à un canal d'entrée d'un circuit de lecture (26) ; et
réinitialiser le condensateur de référence (16) avant une application ultérieure de la tension de commande, le procédé étant **caractérisé en ce que** la réinitialisation consiste à fixer la borne de commande (22) de la VCI de détection (20) à une tension de réinitialisation (Vᵣₑₛₑₜ) sélectionnée pour accorder la sensibilité des pixels (12), et la tension de réinitialisation (Vᵣₑₛₑₜ) étant sélectionnée sur la base d'une région linéaire de fonctionnement de la VCI de détection (20).

11. Procédé selon la revendication 10, consistant en outre à appliquer la tension de commande à une borne de commande (40) d'une VCI de sélection (38) pour connecter le chemin de conduction de la VCI de détection (20) à une alimentation en signal de référence.

12. Réseau de capteurs (10) comprenant une pluralité de pixels sensibles au toucher (12), chaque pixel (12) comprenant :
une électrode de détection capacitive (14) pour accumuler une charge en réponse à la proximité d'un objet conducteur à détecter ;
un condensateur de référence (16) connecté en série à l'électrode de détection capacitive (14) de telle sorte que, en réponse à une tension de commande, une tension indicatrice soit fournie au niveau de la connexion (18) entre le condensateur de référence (16) et l'électrode de détection capacitive (14) pour indiquer la proximité de l'objet conducteur à détecter ;
une impédance commandée en tension de détection (VCI) (20) comportant une borne de commande (22) connectée de telle sorte que l'impédance de la VCI de détection (20) soit commandée par la tension indicatrice,
le réseau de capteurs étant **caractérisé en ce qu'**un chemin de conduction de la VCI de détection (20) connecte une alimentation en signal de référence (28) à une entrée d'un circuit de lecture (26) ; et
une VCI de sélection (38) comportant un chemin de conduction connecté en série entre le chemin de conduction de la VCI de détection (20) et l'alimentation en signal de référence (28).

13. Réseau de capteurs (10) selon la revendication 12, chaque pixel (12) comprenant un circuit de réinitialisation pour fixer la borne de commande (22) de la VCI de détection (20) à une tension de réinitialisation (Vᵣₑₛₑₜ) sélectionnée pour accorder la sensibilité du pixel (12).

14. Réseau de capteurs (10) selon la revendication 13, le circuit de réinitialisation comprenant une VCI de réinitialisation (34), un chemin de conduction de la VCI de réinitialisation (34) étant connecté entre une seconde plaque du condensateur de référence (16) et une tension de réinitialisation (Vᵣₑₛₑₜ).

15. Procédé de fonctionnement d'un réseau de capteurs (10) comprenant une pluralité de pixels sensibles au toucher (12), le procédé consistant à :
appliquer une tension de commande à un condensateur de référence (16) d'un pixel (12) du capteur pour charger le condensateur de référence (16) et une électrode de détection capacitive (14), le condensateur de référence (16) et l'électrode de détection capacitive (14) fournissant ensemble, en réponse à la tension de commande, une tension indicatrice indiquant la proximité d'un objet conducteur à détecter par le pixel (12) ;
utiliser la tension indicatrice pour commander l'impédance d'un chemin de conduction d'une impédance commandée en tension de détection (VCI) (20) connectée à un canal d'entrée d'un circuit de lecture (26) ; et
faire fonctionner une VCI de sélection (38), **caractérisée en ce qu'**elle comporte un chemin de conduction connecté en série entre le chemin de conduction de la VCI de détection (20) et une alimentation en signal de référence (28), pour connecter une alimentation en signal de référence (28) au canal d'entrée du circuit de lecture (26) par l'intermédiaire du chemin de conduction de la VCI de détection (20).
